# FASCICULE DE BREVET EUROPEEN

(11) **EP 3 812 811 B1**
(45) Date de publication et mention de la délivrance du brevet: **12.07.2023**
(21) Numéro de dépôt: 20202961.7
(22) Date de dépôt: 21.10.2020
(51) Int. Cl.: G02B 6/122, G02B 6/136, H01S 5/02, G02B 6/12, G02B 6/132, G02B 6/42, H01S 5/10, H01S 5/20, H01S 5/22

(54) **PROCÉDÉ DE FABRICATION D'UNE PUCE PHOTONIQUE PAR REPORT D'UNE VIGNETTE SUR UN SUBSTRAT DE RÉCEPTION**
VERFAHREN ZUR HERSTELLUNG EINES PHOTONISCHEN CHIPS DURCH ÜBERTRAGUNG EINER VIGNETTE AUF EINEM EMPFANGSSUBSTRAT
METHOD FOR FABRICATING A PHOTONIC CHIP VIA TRANSFER OF A DIE TO A RECEIVING SUBSTRATE

(30) Priorité: 25.10.2019 FR 1911989
(43) Date de publication de la demande: 28.04.2021
(73) Titulaire: Commissariat à l'Energie Atomique et aux Energies Alternatives, 75015 Paris (FR)
(72) Inventeur: MENEZO, Sylvie, 38054 Grenoble cedex 09 (FR); SZELAG, Bertrand, 38054 Grenoble Cedex 09 (FR)
(74) Mandataire: Brevalex

(56) Documents cités:
- WO-A1-2018/087485
- US-A1- 2016 291 265

## Description

### DOMAINE TECHNIQUE

Le domaine de l'invention est celui des procédés de fabrication des puces photoniques comportant une étape de report d'au moins une vignette sur un substrat de réception fonctionnalisé.

### ÉTAT DE LA TECHNIQUE ANTÉRIEURE

D'une manière générale, une puce photonique comporte au moins un composant optoélectronique, par exemple une diode laser, qui repose sur un substrat de réception contenant un circuit photonique intégré. Un tel circuit photonique intégré comporte un guide d'onde couplé optiquement au composant optoélectronique, ainsi que des composants optiques actifs (modulateurs...) et/ou passifs (multiplexeurs...). Dans le cas des technologies de photonique sur silicium, le composant optoélectronique peut être réalisé à base d'un matériau semiconducteur, par exemple un composé III-V tel que de l'InP, et le substrat de réception peut être de type SOI (pour *Silicon On Insulator*, en anglais).

Le procédé de fabrication d'une telle puce photonique peut comporter une étape de report d'une vignette sur le substrat de réception. La vignette est un plot réalisé à base du matériau semiconducteur, et comporte un empilement de plusieurs couches semiconductrices. Le report est effectué de sorte que la vignette soit déposée dans une zone dite de report de la face supérieure du substrat de réception, recouvrant alors au moins en partie un guide d'onde intégré. Une étape de structuration de la vignette III-V est ensuite effectuée pour réaliser le composant optoélectronique, celui-ci étant alors couplé optiquement au guide d'onde intégré. D'une manière générale, le composant optoélectronique peut être une diode laser, une photodiode, un modulateur à électro-absorption, entre autres. Lorsque plusieurs puces photoniques sont réalisées de manière simultanée sur le même substrat de réception, elles sont ensuite individualisées par découpe du substrat de réception.

La demande WO2018/087485A1 décrit un exemple d'un tel procédé de fabrication. Elle mentionne le fait que le report de la vignette sur le substrat de réception peut présenter une incertitude de positionnement dᵢₚ non nulle. De plus, la vignette peut comporter un substrat de croissance, lequel peut être supprimé par gravure humide après l'étape de report. Cette gravure humide peut provoquer une sur-gravure latérale d_{sgl} de la vignette dans un plan parallèle au plan du substrat de réception. Aussi, pour que la vignette présente *in fine* les dimensions souhaitées (Lv^{(f)},lv^{(f)}) pour permettre de réaliser le ou les composants optoélectroniques, par exemple des dimensions égales à 1×1mm², il importe de tenir compte de l'incertitude de positionnement dᵢₚ et de la sur-gravure latérale d_{sgl}, et donc de reporter une vignette présentant des dimensions initiales (Lv⁽ⁱ⁾,lv⁽ⁱ⁾) plus importantes, par exemple de l'ordre de 2×2mm². Par ailleurs, il existe un besoin d'améliorer ce type de procédé de fabrication.

### EXPOSÉ DE L'INVENTION

L'invention a pour objectif de remédier au moins en partie aux inconvénients de l'art antérieur, et plus particulièrement de proposer un procédé de fabrication d'une puce photonique qui préserve l'intégrité structurelle du ou des guides d'onde intégrés couplés optiquement au composant optoélectronique.

Pour cela, l'objet de l'invention revendiquée est un procédé de fabrication d'une puce photonique comportant au moins un composant optoélectronique disposé sur un substrat de réception et couplé optiquement à un premier guide d'onde dit intégré, le procédé comportant les étapes suivantes :
- définition d'une zone centrale Zc, sur une face supérieure du substrat de réception, présentant des dimensions prédéfinies Lc, le dans le plan du substrat de réception, destinée à être entièrement recouverte par une vignette à la suite d'une étape de report de celle-ci sur le substrat de réception compte tenu d'une incertitude de positionnement dᵢₚ prédéfinie de la vignette autour de la zone centrale Zc ;
- réalisation de la vignette, présentant des dimensions initiales Lv⁽ⁱ⁾, lv⁽ⁱ⁾ prédéterminées à partir des dimensions Lc, lc et de l'incertitude de positionnement dᵢₚ ;
- réalisation du substrat de réception, la face supérieure comportant la zone centrale Zc, et une zone périphérique Zp entourant la zone centrale Zc et destinée à être partiellement recouverte par la vignette à la suite de l'étape de report, formant ensemble une zone de report effectif Zrₑ dans laquelle la vignette est destinée à être entièrement située, le substrat de réception comportant :
   o le premier guide d'onde, s'étendant uniquement dans la zone centrale Zc ; et
   o un deuxième guide d'onde, superposé et couplé optiquement au premier guide d'onde, s'étendant au moins dans la zone périphérique Zp, et présentant un espacement e_{gap}⁽²⁾, vis-à-vis de la face supérieure, supérieure à une valeur seuil Pₜₕ prédéterminée ;
- report de la vignette dans la zone de report effectif Zrₑ du substrat de réception, la zone centrale Zc est alors entièrement recouverte par la vignette, et la zone périphérique Zp présentant alors une surface libre non recouverte par la vignette ;
- dépôt d'un masque de gravure sur une portion de la vignette d'une part, et autour de la zone de report effectif Zrₑ d'autre part ;
- réalisation du composant optoélectronique à partir de la vignette, par gravure sèche d'une portion libre de la vignette non revêtue par le masque de gravure, la surface libre de la zone périphérique Zp étant alors gravée sur une profondeur p_{sgv}^{(a)} inférieure ou égale à la valeur seuil Pₜₕ.

Certains aspects préférés mais non limitatifs de ce procédé de fabrication sont les suivants.

Le premier guide d'onde peut présenter un espacement e_{gap}⁽¹⁾, vis-à-vis de la face supérieure, inférieur à la valeur seuil Pₜₕ prédéterminée. L'espacement est défini suivant un axe orthogonal au plan du substrat de réception.

Le substrat de réception peut comporter un troisième guide d'onde, superposé et couplé optiquement au deuxième guide d'onde, s'étendant au moins dans la zone de report effectif Zrₑ, et présentant un espacement e_{gap}⁽³⁾, vis-à-vis de la face supérieure, inférieure à la valeur seuil Pₜₕ prédéterminée. Le troisième guide d'onde peut présenter un espacement e_{gap}⁽³⁾ égal à e_{gap}⁽¹⁾.

A la suite de l'étape de réalisation de la vignette, celle-ci peut présenter des dimensions initiales Lv⁽ⁱ⁾, lv⁽ⁱ⁾ au moins égales respectivement à Lc+2dᵢₚ, lc+2dᵢₚ.

La zone de report effectif Zrₑ peut présenter des dimensions Lrₑ, lrₑ au moins égales respectivement à Lc+4dᵢₚ, 1c+4dᵢₚ.

Le procédé de fabrication peut comporter, avant l'étape de réalisation du composant optoélectronique, une étape de suppression d'un substrat de croissance de la vignette par gravure humide, celle-ci se traduisant par une sur-gravure latérale de la vignette dans un plan parallèle au substrat de réception sur une distance d_{sgl} non nulle, la vignette présentant alors des dimensions initiales Lv⁽ⁱ⁾, lv⁽ⁱ⁾ prédéterminées à partir en outre de la distance d_{sgl}.

Le procédé de fabrication peut comporter une étape de réalisation d'une pluralité de composants optoélectroniques à partir de la même vignette, chaque composant optoélectronique étant couplé à un premier guide d'onde correspondant.

Le composant optoélectronique peut être une diode laser, une photodiode ou un modulateur électro-optique.

La vignette peut être réalisée à base d'un composé semiconducteur III-V.

Le composant optoélectronique peut être une diode laser DFB, un miroir de Bragg étant disposé dans le premier guide d'onde.

Le composant optoélectronique peut être une diode laser de type DBR, deux miroirs de Bragg délimitant la cavité optique de la diode laser et étant disposés dans des deuxièmes guides d'onde couplés chacun à une extrémité du premier guide d'onde.

Le procédé de fabrication peut assurer la fabrication simultanée d'une pluralité de puces photoniques à partir du même substrat de réception.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1F sont des vues schématiques et partielles, en coupe transversale, illustrant différentes étapes d'un exemple de procédé de fabrication d'au moins une puce photonique, mettant en évidence une dégradation structurelle locale du guide d'onde intégré ;
la figure 2A est une vue schématique et partielle, en vue de dessus, d'une vignette reportée sur un substrat de réception, mettant en évidence une zone centrale Zc, une zone de report cible Zr, et une zone de report effectif Zrₑ ;
la figure 2B est une vue schématique et partielle, en vue de dessus, de deux exemples de vignette reportée sur un substrat de réception, avant l'étape de gravure humide du substrat de croissance, pour deux positionnements de la vignette dans la zone de report effectif Zrₑ ;
la figure 2C est une vue schématique et partielle, en vue de dessus, des deux exemples de vignette reportée sur un substrat de réception, tels qu'illustrés sur la fig.2B, après l'étape de gravure humide du substrat de croissance ;
les figures 3A à 3I sont des vues schématiques et partielles, en coupe transversale, illustrant différentes étapes d'un procédé de fabrication d'au moins une puce photonique selon un mode de réalisation, permettant d'éviter la dégradation structurelle locale des premier et deuxième guides d'onde intégrés.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'une ou plusieurs puces photoniques à partir d'une même vignette reportée sur un substrat de réception fonctionnalisé.

Une puce photonique est un dispositif optoélectronique comportant au moins un composant optoélectronique reposant sur un substrat de réception et couplé optiquement à un guide d'onde intégré situé dans le substrat de réception. Ce guide d'onde forme une partie d'un circuit photonique intégré.

La vignette (*die,* en anglais) comporte une portion semiconductrice destinée à permettre la réalisation du ou des composants optoélectroniques, cette portion semiconductrice étant obtenue par épitaxie à partir d'un substrat de croissance. La vignette peut présenter des dimensions initiales (Lv⁽ⁱ⁾, lv⁽ⁱ⁾) dans un plan parallèle au substrat de réception de l'ordre d'un à plusieurs millimètres carrés, et une épaisseur de l'ordre de quelques dizaines à centaines de microns. On note ici L la longueur de la vignette et 1 sa largeur. La vignette peut présenter une forme initiale polygonale, par exemple carrée ou rectangulaire, ou une forme circulaire ou ovale.

Le composant optoélectronique peut notamment être une diode laser ou une photodiode. Il est réalisé à base d'un matériau semiconducteur, c'est-à-dire qu'il comporte majoritairement le matériau semiconducteur en question. Il peut ainsi comporter un empilement de couches minces réalisées en différents composés semiconducteurs contenant le matériau semiconducteur. De préférence, le composant optoélectronique est de type III-V, et peut être réalisé à base d'InP ou de GaAs. La vignette est alors appelée vignette III-V. Le composant optoélectronique peut comporter une hétérostructure formée d'une couche dopée N, d'une couche dopée P, et d'une couche active intercalaire contenant des puits quantiques.

Le substrat de réception est dit fonctionnalisé dans le sens où il comporte au moins un guide d'onde intégré dans le substrat, c'est-à-dire réalisé au niveau de ou sous la face supérieure du substrat de réception. Il peut également comporter d'autres composants optiques passifs (multiplexeurs ou démultiplexeurs, coupleurs à fibre optique...) et/ou des composants optiques actifs (modulateurs...), optiquement couplés les uns aux autres de manière à former le circuit photonique intégré. Le substrat de réception peut être de type SOI, c'est-à-dire qu'il peut comporter une couche mince de silicium et un substrat support en silicium, entre lesquelles est intercalée une couche d'oxyde dite BOX (*buried oxide*, en anglais). La couche mince de silicium peut être recouverte d'une couche mince permettant le collage de la vignette sur la face supérieure du substrat de réception, par exemple une couche d'oxyde dans le cas d'un collage par adhésion moléculaire.

D'une manière générale, la puce photonique peut être un transmetteur Tx dans lequel on peut retrouver des diodes laser couplées chacune à un guide d'onde intégré, ainsi que, par exemple, des modulateurs, au moins un multiplexeur, et un coupleur vers une fibre optique. La puce photonique peut également être un récepteur Rx comportant un coupleur, un démultiplexeur, et des photodiodes. Elle peut également être un transmetteur-récepteur comportant à la fois des diodes laser et des photodiodes. Dans la suite de la description, à titre purement illustratif, la puce photonique est un transmetteur comportant au moins une diode laser réalisée en un composé III-V, couplée optiquement à un premier guide d'onde d'un circuit photonique intégré, ce guide d'onde étant intégré dans un substrat de réception réalisé à base de silicium, par exemple de type SOI.

Par ailleurs, le procédé de fabrication met en oeuvre au moins une étape de structuration de la vignette par gravure sèche (*dry etching,* en anglais), de manière à réaliser le ou les composants optoélectroniques. La gravure sèche consiste en un bombardement par des ions de la surface libre de la vignette, c'est-à-dire la surface non protégée par un masque de gravure (également appelé masque dur). Il s'agit d'une gravure essentiellement physique qui présente en conséquence un caractère fortement anisotrope. Il peut ainsi s'agir, par exemple, d'une gravure ionique réactive (RIE, pour *Reactive Ion Etching,* en anglais) éventuellement par plasma à couplage inductif (ICP, pour *Inductively Coupled Plasma,* en anglais).

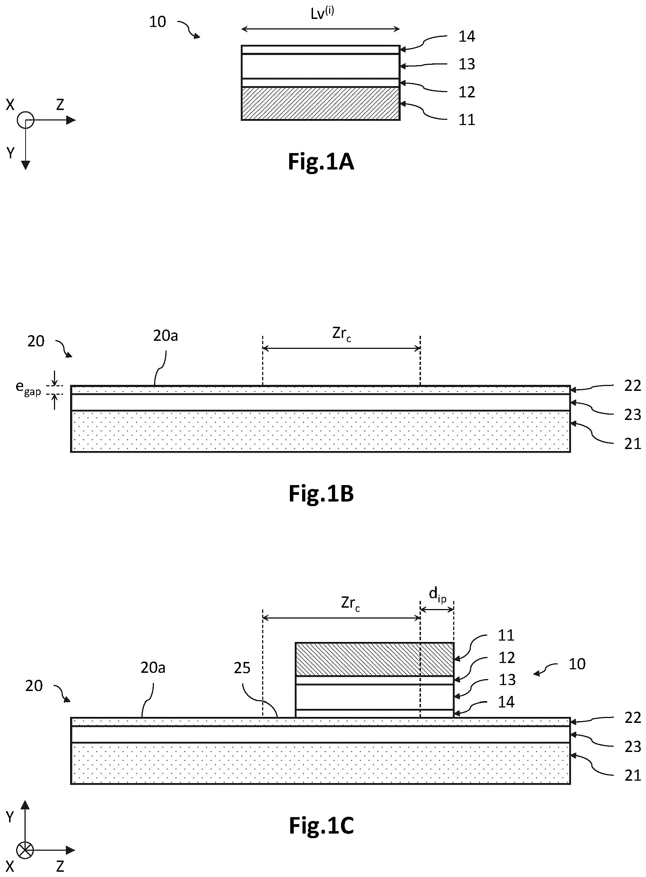

Les figures 1A à 1F illustrent différentes étapes d'un exemple de procédé de fabrication d'une puce photonique 1, mettant en évidence lors d'une étape de gravure sèche de la vignette 10, une dégradation structurelle locale du guide d'onde intégré 23 couplé optiquement au composant optoélectronique. Dans cet exemple, la puce photonique 1 est ici un transmetteur, et la vignette 10 est destinée à réaliser au moins une diode laser. La vignette 10 est de type III-V et est réalisée à base d'InP, et le substrat de réception 20 est de type SOI.

On définit ici et pour la suite de la description un repère direct tridimensionnel orthogonal XYZ, où le plan XZ est un plan parallèle au plan du substrat de réception 20, l'axe Z étant orienté suivant l'axe longitudinal du guide d'onde intégré 23, l'axe X étant orienté suivant la largeur du guide d'onde 23, et où l'axe Y est orienté du substrat de réception 20 vers la vignette 10.

En référence à la fig.1A, on réalise une vignette 10 à partir de laquelle sera réalisé le composant optoélectronique, ici une diode laser. La vignette 10 est formée ici d'un empilement comportant un substrat de croissance 11 réalisé en InP, une couche semiconductrice 12 dopée selon un premier type de conductivité, ici en InP dopé P et une couche active 13 comportant des puits quantiques en InGaAsP/InAsP, et une couche semiconductrice 14 dopée selon un deuxième type de conductivité opposé au premier type, ici en InP dopé N.

La vignette 10 présente des dimensions initiales (Lv⁽ⁱ⁾, lv⁽ⁱ⁾) dans le plan XZ, c'est-à-dire une longueur initiale Lv⁽ⁱ⁾ suivant l'axe Z et une largeur initiale lv⁽ⁱ⁾ suivant l'axe X. Ces dimensions initiales (Lv⁽ⁱ⁾, lv⁽ⁱ⁾) dépendent ici d'une sur-gravure latérale d_{sgl} de la vignette 10 qui a lieu lors du retrait du substrat de croissance 11 par gravure humide, ainsi que des dimensions finales (Lv^{(f)}, lv^{(f)}) souhaitées de la vignette 10. Les dimensions finales (Lv^{(f)}, lv^{(f)}) correspondent aux dimensions de la vignette 10 avant l'étape de gravure sèche mise en oeuvre pour former le composant optoélectronique. A titre d'exemple, les dimensions finales (Lv^{(f)}, lv^{(f)}) souhaitées sont 1×1mm² et la sur-gravure latérale d_{sgl} est ici de l'ordre de 100µm. Aussi, les dimensions initiales (Lv⁽ⁱ⁾, lv⁽ⁱ⁾) sont ici au moins égales à 1.2×1.2mm². Des dimensions finales (Lv^{(f)}, lv^{(f)}) de 1×1mm² permettent notamment de réaliser plusieurs diodes laser en ruban à partir d'une même vignette 10, comme l'indique notamment le document WO2018/087485A1, chaque diode laser présentant par exemple une longueur de 800µm environ, une largeur de 50µm environ, avec un espacement inter-diode de 200µm environ.

En référence à la fig.1B, on réalise un substrat de réception 20 comportant au moins un guide d'onde intégré 23 destiné à être couplé optiquement au composant optoélectronique. Le substrat est ici de type SOI. Il comporte un substrat support (non représenté) réalisé par exemple en silicium et présentant une épaisseur de l'ordre de plusieurs centaines de microns, une couche 21 d'oxyde enterré (BOX) qui recouvre le substrat support, et un guide d'onde intégré 23. Le guide d'onde 23 présente ici un coeur en silicium et est entouré par un oxyde. Dans cet exemple, il est revêtu d'une fine couche d'oxyde 22, dont notamment une couche de collage, ici réalisée en un oxyde de silicium, qui définit la face supérieure 20a du substrat de réception 20. Elle présente une épaisseur de l'ordre de quelques dizaines de nanomètres, par exemple une épaisseur comprise entre 20nm et 100nm environ. Il est possible en variante que cette couche de collage soit absente. Le guide d'onde 23, et plus précisément sa face supérieure, est espacé de la face supérieure 20a du substrat de réception 20 d'une distance e_{gap} suivant l'axe Y qui peut être comprise entre zéro (pas de couche d'oxyde 22 au-dessus du guide d'onde 23) et par exemple quelques dizaines de nanomètres.

On définit par ailleurs une zone de report cible Zr_{c} dans la face supérieure 20a du substrat de réception 20, dans laquelle la vignette 10 est censée être située après l'étape de report. Cette zone de report cible Zr_{c} présente ici des dimensions identiques aux dimensions initiales (Lv⁽ⁱ⁾, lv⁽ⁱ⁾) de la vignette 10. Le guide d'onde intégré 23 s'étend continûment dans et hors de la zone de report cible Zr_{c}

En référence à la fig.1C, on reporte ensuite la vignette 10 sur le substrat de réception 20 dans la zone de report cible Zr_{c}, de manière à recouvrir le guide d'onde intégré 23. La vignette 10 est fixée au substrat de réception 20 par collage direct de type oxyde/oxyde. Cependant, du fait d'une incertitude de positionnement dᵢₚ associée au dispositif de report utilisé, la vignette 10 n'est pas disposée exactement dans la zone de report cible Zr_{c} mais présente un décalage d'une valeur dᵢₚ prédéfinie, et indiquée par exemple dans les spécifications du dispositif de report. Dans cet exemple, elle est reportée avec un décalage de positionnement dᵢₚ de 300µm suivant la direction +Z. Aussi, dans la zone de report cible Zr_{c}, le substrat de réception 20 présente une surface libre 25, c'est-à-dire une surface non revêtue par la vignette 10. Par ailleurs, la vignette 10 présente une portion située hors de la zone de report cible Zr_{c}.

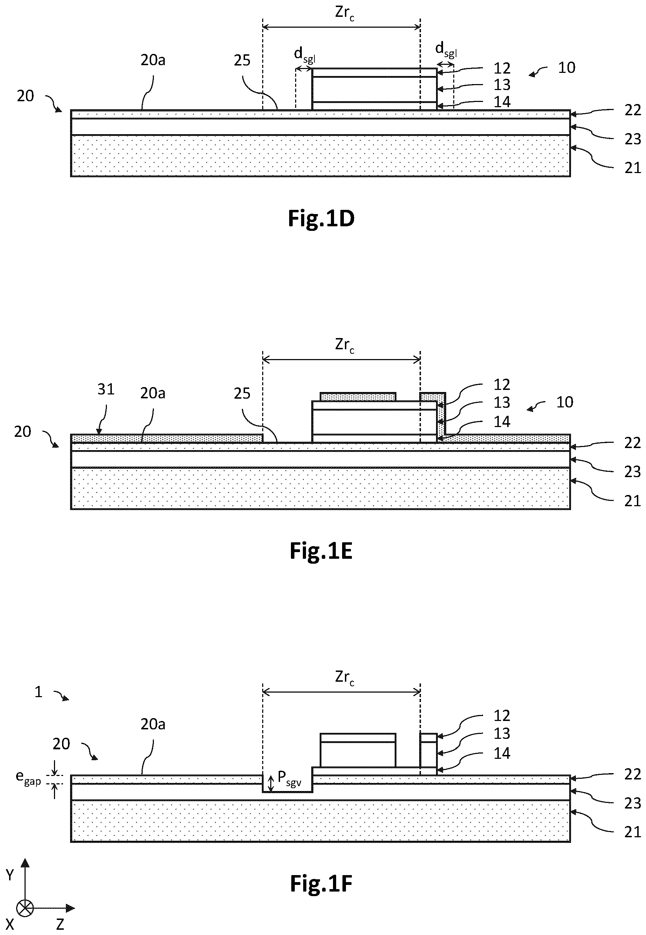

En référence à la fig.1D, on supprime ensuite le substrat de croissance 11, ici par gravure humide à l'acide chlorhydrique, éventuellement précédée d'un amincissement mécanique, de manière à rendre libre ici la couche semiconductrice 12 dopée P. Cette étape de gravure humide s'accompagne ici d'une sur-gravure latérale de la vignette 10 de manière isotrope dans le plan XZ, et d'une valeur d_{sgl} égale par exemple à 100µm environ, de sorte que la vignette 10 présente alors des dimensions finales (Lv^{(f)}, lv^{(f)}) ici égales à 1×1mm².

En référence à la fig.1E, on dépose ensuite un masque dur 31, par exemple réalisé en un nitrure de silicium, de manière, d'une part à entourer la zone de report cible Zr_{c}, et d'autre part à revêtir une portion de la vignette 10 destinée à former le composant optoélectronique. Il apparaît que le masque dur 31 ne s'étend pas entièrement jusqu'à la bordure de la vignette 10 dans le plan XZ : le substrat de réception 20 présente alors une surface libre 25 dans la zone de report cible Zr, située entre le masque dur 31 et la vignette 10. De plus, le masque dur 31 recouvre la portion de la vignette 10 située en-dehors de la zone de report cible Zr_{c}.

En référence à la fig.1F, on structure la vignette 10 en vue de réaliser le composant optoélectronique. Pour cela, on effectue une gravure sèche pour supprimer les portions de la vignette 10 non revêtues par le masque dur 31. La gravure sèche peut être, par exemple, une gravure RIE. Dans cet exemple, elle est essentiellement anisotrope et présente ici une sur-gravure latérale sensiblement nulle.

Les inventeurs ont constaté que l'incertitude de positionnement dᵢₚ de la vignette 10 peut conduire à une dégradation structurelle locale du guide d'onde intégré 23 au niveau de la zone de report cible Zr_{c}. En effet, dans cet exemple, la surface libre 25 du substrat de réception 20 peut être gravée sur une profondeur P_{sgv} dont la valeur dépend notamment des conditions opératoires de gravure et de la nature des matériaux gravés. Il apparaît que cette valeur P_{sgv} de sur-gravure verticale peut être supérieure à l'espacement e_{gap} entre le guide d'onde 23 et la face supérieure 20a du substrat de réception 20. La profondeur P_{sgv} de sur-gravure verticale peut atteindre une valeur de l'ordre de 75nm, et ainsi conduire à une gravure au moins partielle du guide d'onde intégré 23 lorsque l'espacement e_{gap} est inférieur à cette valeur P_{sgv}. Celui-ci présente alors une dégradation structurelle locale qui peut conduire à une diminution des performances de la puce photonique 1. Par ailleurs, cette détérioration locale du guide d'onde intégré 23 peut être accentuée lorsque le procédé de fabrication comporte au moins une étape supplémentaire de gravure sèche, par exemple lors de la structuration de la couche semiconductrice 14 d'InP dopée N. Une nouvelle sur-gravure verticale du substrat de réception 20 par exemple d'une valeur de 75nm environ peut alors avoir lieu, aggravant la dégradation locale de la structure du guide d'onde intégré 23.

Par ailleurs, comme l'illustre la fig.1F, le décalage de la vignette 10 hors de la zone de report cible Zr, conduit à la formation de mur(s) ou plot(s) non souhaités. Ces zones parasites à topologie tridimensionnelle peuvent perturber les étapes suivantes du procédé de fabrication, que ce soit les étapes de lithographie et gravure ou celles de dépôt de couche mince (notamment pour réaliser les électrodes de polarisation).

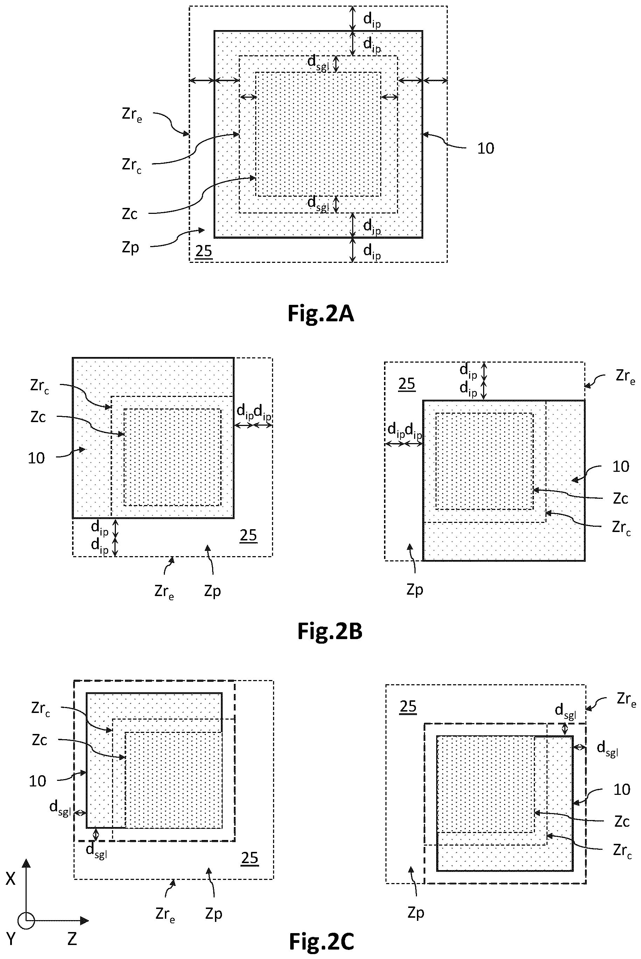

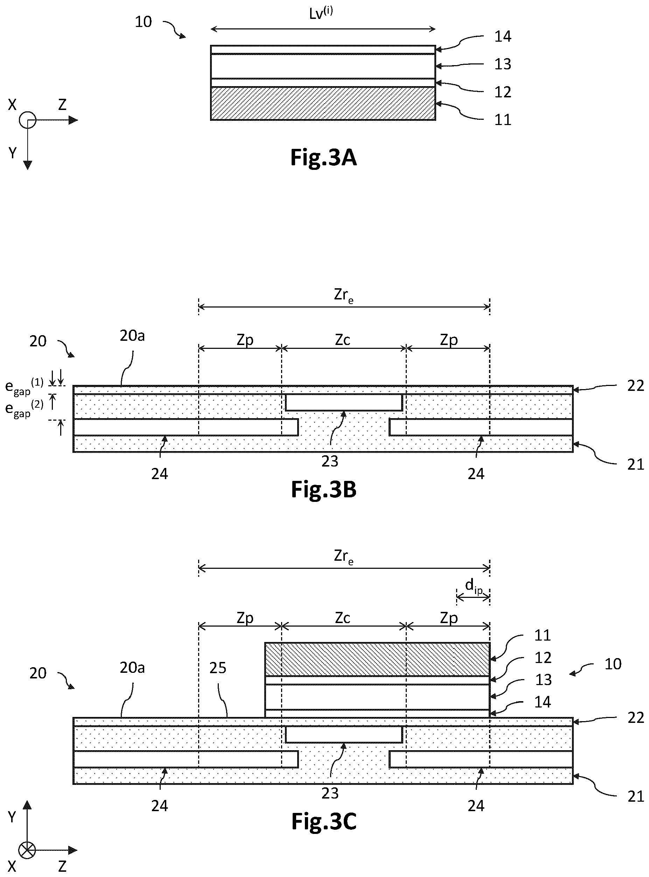

Un procédé de fabrication d'une puce photonique 1 selon un mode de réalisation est maintenant décrit en référence aux figures 2A à 2C, et 3A à 3I. Ce procédé permet d'écarter les risques de dégradation du ou des guides d'onde intégrés couplés directement ou indirectement au composant optoélectronique lors de la sur-gravure verticale du substrat de réception 20.

En référence à la fig.2A, on définit une zone centrale Zc de dimensions (Lc, le) sur la face supérieure 20a du substrat de réception 20, permettant de réaliser le ou les composants optoélectroniques, cette zone centrale Zc étant destinée à être entièrement recouverte par la vignette 10 à la suite de l'étape de report, quelle que soit la position effective de la vignette 10 du fait de l'incertitude de positionnement dᵢₚ autour de la zone centrale Zc. Dans cet exemple, la zone centrale Zc présente des dimensions (Lc, le) égales ici à 1× 1mm² permettant de réaliser plusieurs diodes en ruban.

On souhaite que la vignette 10, après l'étape de suppression du substrat de croissance 11 par gravure humide, présente des dimensions finales au moins égales à (Lc, le). La zone de report cible Zr, correspond donc à la zone centrale Zc augmentée d'une distance d_{sgl} liée à la sur-gravure latérale qui a lieu lors de la gravure humide du substrat de croissance 11. Cette zone de report cible Zr, est donc centrée sur la zone centrale Zc et présente des dimensions (Lr_{c}, 1c_{c}) au moins égales à (Lc+2d_{sgl}, 1c+2d_{sgl}).

Pour tenir compte de l'incertitude de positionnement de la vignette 10 autour de la zone de report cible Zr_{c} d'une valeur dᵢₚ ici égale à 300µm, la vignette 10 présente des dimensions initiales (Lv⁽ⁱ⁾, lv⁽ⁱ⁾) au moins égales à (Lr_{c}+2dᵢₚ, 1r_{c}+2dᵢₚ), donc au moins égales à (Lc+2d_{sgl}+2dᵢₚ, 1c+2d_{sgl}+2dᵢₚ), soit ici au moins égales à 1.8×1.8mm². On peut donc définir une zone de report effectif Zrₑ comme étant la zone dans laquelle la vignette 10 sera entièrement située après l'étape de report, en tenant compte de l'incertitude de positionnement dᵢₚ autour de la zone de report cible Zr_{c}. Cette zone de report effectif Zrₑ est donc centrée sur la zone centrale Zc et présente des dimensions (Lrₑ, 1rₑ) au moins égales à (Lc+2d_{sgl}+4dᵢₚ, 1c+2d_{sgl}+4dᵢₚ), soit ici au moins égales à 2.4×2.4mm².

Autrement dit, la zone de report effectif Zrₑ est la zone du substrat de réception 20 entourant la zone centrale Zc, dans laquelle la vignette 10 sera effectivement reportée compte tenu de l'incertitude de positionnement dᵢₚ prédéfinie et ici de la sur-gravure latérale d_{sgl} prédéfinie liée à la gravure humide du substrat de croissance 11. La vignette 10 sera donc entièrement située dans cette zone de report effectif Zrₑ, dans le sens où elle ne sera pas en partie située hors de cette zone Zrₑ.

De plus, le report d'une vignette 10 de dimensions initiales (Lv⁽ⁱ⁾, lv⁽ⁱ⁾) définies précédemment dans la zone de report effectif Zrₑ permet d'être assuré que la zone centrale Zc sera bien entièrement recouverte par la vignette 10 après l'étape de report, et ici également après l'étape de gravure humide du substrat de croissance 11. Autrement dit, la zone centrale Zc ne comporte pas de surface libre non revêtue par la vignette 10. La zone centrale Zc est délimitée par une bordure périphérique qui est distante d'une valeur d_{sgl}+2dᵢₚ vis-à-vis de la bordure périphérique de la zone de report effectif Zrₑ.

La zone périphérique Zp est la surface de la zone de report effectif Zrₑ qui entoure la zone centrale Zc. Elle est donc destinée à n'être que partiellement recouverte par la vignette 10 après l'étape de report. Aussi, elle est destinée à présenter une surface dite libre 25, c'est-à-dire non recouverte par la vignette 10, qui sera soumise à une sur-gravure verticale d'une profondeur seuil prédéterminée Pₜₕ, lors de l'étape ou des étapes de gravure sèche mises en oeuvre par le procédé de fabrication.

La fig.2B illustre deux exemples de positionnement de la vignette 10 dans la zone de report effectif Zrₑ prédéfinie, avant l'étape de gravure humide du substrat de croissance 11. Dans un exemple, la vignette 10 est positionnée dans un coin (en haut à gauche) de la zone de report effectif Zrₑ et dans l'autre exemple, elle est positionnée dans le coin opposé (en bas à droite). On remarque que, quelle que soit l'incertitude de positionnement de la vignette 10, celle-ci recouvre toujours la zone centrale Zc, et ici également la zone de report cible Zr_{c}. La zone périphérique Zp présente une surface libre 25 susceptible de subir la sur-gravure verticale lors de l'étape de gravure sèche.

La fig.2C illustre les deux exemples de positionnement de la vignette 10 illustrés sur la fig.2B, mais après l'étape de gravure humide du substrat de croissance 11. La vignette 10 est donc passée des dimensions initiales (Lv⁽ⁱ⁾, lv⁽ⁱ⁾) aux dimensions finales (Lv^{(f)}, lv^{(f)}) réduites de la valeur d_{sgl}. Ici également, la vignette 10 recouvre entièrement la zone centrale Zc mais ne recouvre que partiellement la zone périphérique Zp. Une surface libre 25 est donc présente, qui pourra subir la sur-gravure verticale.

Les figures 3A à 3I illustrent différentes étapes du procédé de fabrication selon le mode de réalisation, permettant d'éviter une dégradation locale de la structure des guides d'onde intégrés couplés au composant optoélectronique.

En référence à la fig.3A, on réalise la vignette 10. Celle-ci comporte, comme précédemment, un substrat de croissance 11, ici en InP, éventuellement une couche sacrificielle en InGaAs (non représentée), une couche semiconductrice 12 dopée, ici en InP dopé P, une couche active 13 comportant des puits quantiques, par exemple en InAsP/InGaAsP, et une couche semiconductrice 14 dopée, ici en InP dopé N. Elle présente des dimensions initiales (Lv⁽ⁱ⁾, lv⁽ⁱ⁾) qui tiennent compte des dimensions Lc, le de la zone centrale Zc (ici 1×1mm² environ), de l'incertitude de positionnement dᵢₚ (ici 300µm environ), et de la sur-gravure latérale d_{sgl} (ici 100µm environ). Autrement dit, les dimensions initiales (Lv⁽ⁱ⁾, lv⁽ⁱ⁾) de la vignette 10 sont au moins égales à (Lc+2dᵢₚ+2d_{sgl})×(1c+2dᵢₚ+2d_{sgl}), soit ici au moins égales à 1.8×1.8mm² environ.

En référence à la fig.3B, on réalise le substrat de réception 20. Il comporte ici un substrat support (non représenté), par exemple en silicium, une couche 21 d'oxyde BOX, au moins deux guides d'onde intégrés 23, 24, et une couche d'oxyde 22 espaçant le premier guide d'onde 23 vis-à-vis du substrat de réception 20. Plus précisément, le substrat de réception 20 comporte :
- un premier guide d'onde 23 destiné à être couplé optiquement au composant optoélectronique, s'étendant dans le plan XZ uniquement dans la zone centrale Zc, et présentant un espacement e_{gap}⁽¹⁾ suivant l'axe Y vis-à-vis de la face supérieure 20a du substrat de réception 20 pouvant être inférieure ou égale à la valeur seuil Pₜₕ, et
- au moins un deuxième guide d'onde 24 superposé suivant l'axe Y et couplé optiquement au premier guide d'onde 23, s'étendant dans le plan XZ au moins dans la zone périphérique Zp, et présentant un espacement e_{gap}⁽²⁾ suivant l'axe Y vis-à-vis de la face supérieure 20a du substrat de réception 20 supérieure à la valeur seuil Pₜₕ.

Le premier guide d'onde 23, destiné à être couplé optiquement au composant optoélectronique, s'étend dans le plan XZ uniquement dans la zone centrale Zc. Autrement dit, il ne s'étend pas dans la zone périphérique Zp. Du fait de sa disposition dans le plan XZ, et malgré un éventuel faible espacement e_{gap}⁽¹⁾ vis-à-vis de la face supérieure 20a du substrat de réception 20, lequel est défini de manière à optimiser le couplage optique avec la diode laser, il ne peut subir de dégradation structurelle locale par la sur-gravure verticale du substrat de réception 20, et ce quelle que soit la position effective de report de la vignette 10 dans la zone Zrₑ du fait de l'incertitude de positionnement dᵢₚ prédéfinie, et quelle que soit l'éventuelle sur-gravure latérale de valeur d_{sgl} prédéfinie lors de la gravure humide du substrat de croissance 11. En effet, il n'est pas situé dans la zone périphérique Zp et n'est donc pas susceptible de subir la sur-gravure verticale liée à la gravure sèche.

Le deuxième guide d'onde 24 est superposé suivant l'axe Y au premier guide d'onde 23, et est couplé optiquement à celui-ci. Il s'étend dans le plan XZ au moins dans la zone périphérique Zp. Il s'étend ici également hors de la zone de report Zr d'une part, et également dans la zone centrale Zc sur une distance permettant d'optimiser le couplage optique avec le premier guide d'onde 23 d'autre part. Du fait de son espacement e_{gap}⁽²⁾ supérieur à la valeur seuil Pₜₕ, et malgré sa disposition dans la zone périphérique Zp, il ne peut subir de dégradation par la sur-gravure verticale du substrat de réception 20. On définit Pₜₕ comme étant la valeur maximale de la sur-gravure verticale cumulée dans la zone périphérique Zp à la suite de la ou des différentes étapes de gravure sèche mises en oeuvre dans le procédé de fabrication.

En référence à la fig.3C, on reporte la vignette 10 sur le substrat de réception 20 dans la zone de report effectif Zrₑ. Dans cet exemple, la vignette 10 présente un décalage suivant la direction +Z d'une valeur dᵢₚ ici égale à 300µm environ. Elle reste donc située dans la zone de report effectif Zrₑ telle que définie précédemment, et s'étend nécessairement entièrement dans la zone centrale Zc. Aussi, une surface du substrat de réception 20 dans la zone périphérique Zp est une surface libre 25, c'est-à-dire une surface non revêtue par la vignette 10.

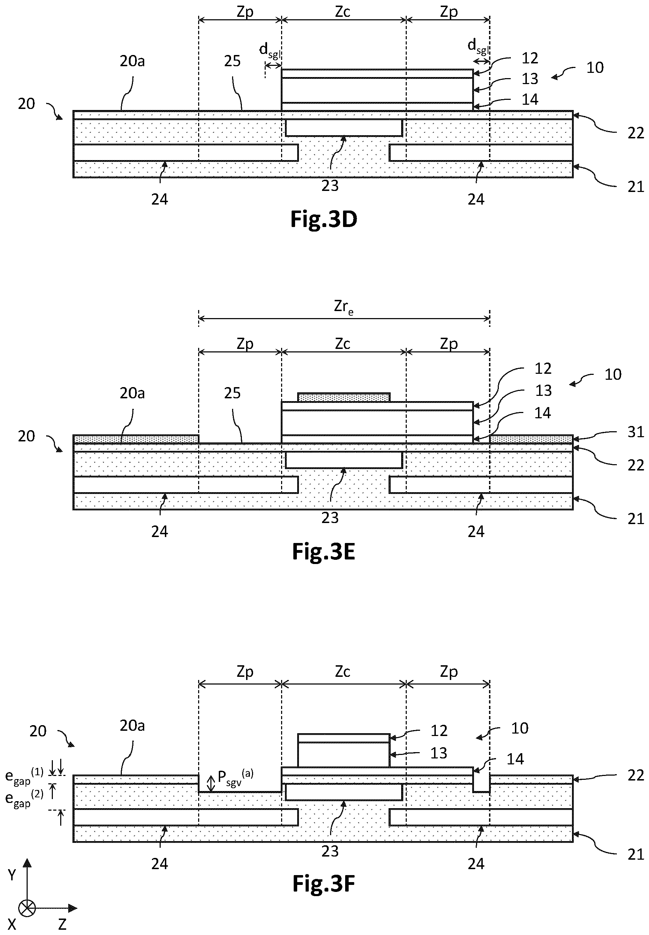

En référence à la fig.3D, on supprime ensuite le substrat de croissance 11, ici par gravure humide, de manière à rendre libre la couche semiconductrice 12 dopée P. Cette étape de gravure humide s'accompagne ici d'une sur-gravure latérale de la vignette 10 de manière isotrope dans le plan XZ, et d'une valeur d_{sgl} ici égale à 100µm environ, de sorte que la vignette 10 présente alors des dimensions (Lc+2dᵢₚ, 1c+2dᵢₚ), ici égales à 1.6×1.6mm².

En référence à la fig.3E, on dépose un masque dur 31, par exemple réalisé en un nitrure de silicium, de manière à revêtir continûment la surface du substrat de réception 20 entourant la zone de report effectif Zrₑ, et à revêtir une portion de la vignette 10 destinée à former le composant optoélectronique (donc située dans la zone centrale Zc). Ainsi, la surface du substrat de réception 20 hors de la zone de report effectif Zrₑ est protégée par le masque dur 31, alors que la zone périphérique Zp présente une surface libre 25, c'est-à-dire non protégée par le masque dur 31. En revanche, la zone centrale Zc est toujours entièrement recouverte par la vignette 10. Par ailleurs, le fait de déposer le masque dur 31 autour de la zone de report effectif Zrₑ et non pas autour de la zone de report cible Zr_{c} permet d'éviter de réaliser des murs et/ou plots non souhaités tels qu'illustrés sur la fig.1F.

En référence à la fig.3F, on structure la vignette 10 en vue de réaliser le composant optoélectronique. Pour cela, on effectue une gravure sèche pour supprimer la portion de la vignette 10 non revêtue par le masque dur 31. La gravure sèche peut être, par exemple, une gravure RIE. Dans cet exemple, elle est essentiellement anisotrope et présente ici une sur-gravure latérale sensiblement nulle. La gravure sèche assure une gravure locale de la couche semiconductrice 12 d'InP dopé P et de la couche active 13, et s'arrête ici sur la couche semiconductrice 14 d'InP dopé N. On supprime ensuite le masque dur 31.

Dans la mesure où la zone périphérique Zp présente une surface libre 25, la gravure sèche se traduit par une sur-gravure verticale de la surface libre 25 du substrat de réception 20 sur une distance P_{sgv}^{(a)}. Dans cet exemple, le procédé de fabrication comporte deux étapes de gravure sèche, qui conduisent chacune à une sur-gravure verticale de valeurs P_{sgv}^{(a)} et P_{sgv}^{(b)}. Aussi, la valeur seuil Pₜₕ est ici sensiblement égale à la somme de P_{sgv}^{(a)} et de P_{sgv}^{(b)}. La valeur seuil Pₜₕ peut être sensiblement égale à 150nm, lorsque P_{sgv}^{(a)} et P_{sgv}^{(b)} sont chacun de l'ordre de 75nm.

Cependant, dans la mesure où le premier guide d'onde 23 est situé uniquement dans la zone centrale Zc, il n'est pas endommagé par la sur-gravure verticale P_{sgv}^{(a)} car il est protégé par la présence de la vignette 10. Et dans la mesure où le deuxième guide d'onde 24 est situé dans la zone périphérique Zp mais avec un espacement supérieur à Pₜₕ, il n'est pas non plus endommagé par la sur-gravure verticale P_{sgv}^{(a)} qui est insuffisante pour l'atteindre.

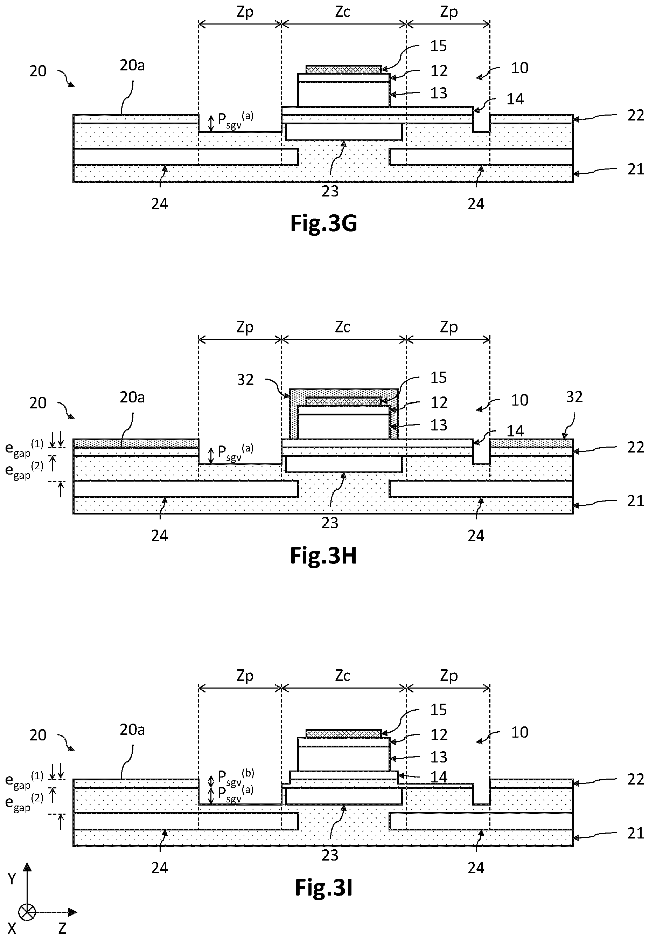

En référence à la fig.3G, on réalise un contact électrique 15 sur la couche semiconductrice 12 d'InP dopé P. Ce contact électrique 15 permet d'injecter un courant électrique de pompage à la diode laser.

En référence à la fig.3H, on dépose un deuxième masque dur 32 en vue de structurer la couche semiconductrice 14 d'InP dopé N. Le masque dur 32 est réalisé, par exemple en nitrure de silicium, et recouvre le contact électrique 15, la couche semiconductrice 12 dopée P et la couche active 13, ainsi qu'une partie périphérique de la couche semiconductrice 14 dopée N. Dans cet exemple, le masque dur 32 s'étend de manière à entourer la zone de report effectif Zrₑ, bien que ce ne soit pas nécessaire dans la mesure où le deuxième guide d'onde 24 présente un espacement supérieur à Pₜₕ : il n'est donc pas susceptible d'être dégradé localement à la suite de la prochaine gravure sèche. Une protection hors de la zone de report effectif Zrₑ est utile lorsque le circuit photonique intégré comporte des guides d'onde présentant un espacement e_{gap} inférieur à P_{sgv}^{(b)}.

En référence à la fig.3I, on structure la couche semiconductrice 14 d'InP dopé N en vue de finaliser la réalisation de la diode laser. Pour cela, on effectue une nouvelle gravure sèche pour supprimer les portions couche semiconductrice 14 d'InP dopé N non revêtues par le masque dur 32. La gravure sèche peut être, par exemple, une gravure RIE. Dans cet exemple, elle est essentiellement anisotrope et présente ici une sur-gravure latérale sensiblement nulle. La gravure sèche assure une gravure locale de la couche semiconductrice 14 d'InP dopé N. On supprime ensuite le masque dur 32.

La gravure sèche se traduit par une nouvelle sur-gravure verticale de la surface libre 25 du substrat de réception 20 sur une distance P_{sgv}^{(b)} qui s'ajoute à la sur-gravure verticale précédente de valeur P_{sgv}^{(a)}. La sur-gravure verticale du substrat de réception 20 de la surface libre 25 de la zone périphérique Zp attend alors la valeur seuil Pₜₕ.

Cependant, dans la mesure où le premier guide d'onde 23 est situé uniquement dans la zone centrale Zc, il n'est pas endommagé par cette nouvelle sur-gravure verticale de valeur P_{sgv}^{(b)}. Et dans la mesure où le deuxième guide d'onde 24 est situé dans la zone périphérique Zp avec un espacement supérieur à Pₜₕ, il n'est pas non plus endommagé par cette sur-gravure verticale de valeur P_{sgv}^{(b)}.

Ainsi, le procédé de fabrication permet d'éviter que la ou les différentes gravures sèches mises en oeuvre, qui induisent une sur-gravure verticale de la surface libre 25 du substrat de réception 20, ne dégradent les guides d'onde intégré, et en particulier les premier et deuxième guides d'onde intégrés. Les performances de la puce photonique 1 sont donc préservées.

Des modes de réalisation particuliers viennent d'être décrits. Différentes variantes et modifications apparaîtront à l'homme du métier.

Ainsi, une même vignette 10 peut permettre de réaliser plusieurs diodes laser. A titre d'exemple, chaque diode laser peut être une diode en ruban, voire être une diode laser à cavité verticale émettant par la surface (VCSEL, pour *Vertical-Cavity Surface-Emitting Laser,* en anglais).

Le procédé de fabrication peut permettre la réalisation simultanée de plusieurs puces photoniques sur le même substrat de réception 20. Il comporte alors une étape de découpe du substrat de réception 20 pour individualiser les puces photoniques.

Dans l'exemple des figures 3, le deuxième guide d'onde 24 s'étend également en-dehors de la zone de report effectif Zrₑ. En variante, le deuxième guide d'onde 24 peut ne s'étendre essentiellement que dans la zone périphérique Zp, et le circuit photonique intégré peut alors comporter au moins un troisième guide d'onde, superposé suivant l'axe Y et couplé optiquement au deuxième guide d'onde 24, et présentant un espacement e_{gap}⁽³⁾ vis-à-vis de la face supérieure 20a du substrat de réception 20 qui est inférieur à la valeur seuil Pₜₕ. Ce troisième guide d'onde peut être coplanaire avec le premier guide d'onde 23. Il est alors situé hors de la zone de report effectif Zrₑ, de manière à être protégé des surgravures verticales du substrat de réception 20 induites par les différentes étapes de gravure sèche.

Dans le cas où le composant optoélectronique est une diode laser, il peut être hybride et comporter alors des réflecteurs délimitant la cavité optique de la source laser situés dans le substrat de réception 20. Ainsi, dans le cas d'un laser à réflecteur de Bragg distribué (DBR, pour *Distributed Bragg Reflector,* en anglais), la cavité optique est délimitée par deux réseaux de Bragg situés dans le premier guide d'onde 23, ou en variante dans le deuxième (ou troisième) guide d'onde. Plus précisément, deux deuxièmes guides d'onde sont couplés optiquement au premier guide d'onde 23, et comportent chacun un miroir de Bragg. Dans le cas d'un laser à rétroaction distribuée (DFB, pour *Distributed FeedBack,* en anglais), un même réseau de Bragg s'étend dans le premier guide d'onde 23 sur toute la longueur de la cavité optique.

## Revendications

1. Procédé de fabrication d'une puce photonique (1) comportant au moins un composant optoélectronique disposé sur un substrat de réception (20) et couplé optiquement à un premier guide d'onde (23) dit intégré, le procédé comportant les étapes suivantes :
o définition d'une zone centrale Zc, sur une face supérieure (20a) du substrat de réception (20), présentant des dimensions prédéfinies Lc, le dans le plan du substrat de réception, destinée à être entièrement recouverte par une vignette (10) à la suite d'une étape de report de celle-ci sur le substrat de réception (20) compte tenu d'une incertitude de positionnement dᵢₚ prédéfinie de la vignette (10) autour de la zone centrale Zc ;
o réalisation de la vignette (10), présentant des dimensions initiales Lv⁽ⁱ⁾, lv⁽ⁱ⁾ prédéterminées à partir des dimensions Lc, le et de l'incertitude de positionnement dᵢₚ ;
o réalisation du substrat de réception (20), la face supérieure (20a) comportant la zone centrale Zc, et une zone périphérique Zp entourant la zone centrale Zc et destinée à être partiellement recouverte par la vignette à la suite de l'étape de report, formant ensemble une zone de report effectif Zrₑ dans laquelle la vignette est destinée à être entièrement située, le substrat de réception (20) comportant :
• le premier guide d'onde (23), s'étendant uniquement dans la zone centrale Zc ; et
• un deuxième guide d'onde (24), superposé et couplé optiquement au premier guide d'onde (23), s'étendant au moins dans la zone périphérique Zp, et présentant un espacement e_{gap}⁽²⁾, vis-à-vis de la face supérieure (20a), supérieure à une valeur seuil Pₜₕ prédéterminée ;
o report de la vignette (10) dans la zone de report effectif Zrₑ du substrat de réception (20), la zone centrale Zc est alors entièrement recouverte par la vignette (10), et la zone périphérique Zp présentant alors une surface libre (25) non recouverte par la vignette ;
o dépôt d'un masque de gravure (31) sur une portion de la vignette (10) d'une part, et autour de la zone de report effectif Zrₑ d'autre part ;
o réalisation du composant optoélectronique à partir de la vignette (10), par gravure sèche d'une portion libre de la vignette (10) non revêtue par le masque de gravure (31), la surface libre (25) de la zone périphérique Zp étant alors gravée sur une profondeur P_{sgv}^{(a)} inférieure ou égale à la valeur seuil Pₜₕ.

2. Procédé de fabrication selon la revendication 1, dans lequel le premier guide d'onde (23) présente un espacement e_{gap}⁽¹⁾, vis-à-vis de la face supérieure (20a), inférieur à la valeur seuil Pₜₕ prédéterminée.

3. Procédé de fabrication selon la revendication 1 ou 2, dans lequel le substrat de réception (20) comporte un troisième guide d'onde, superposé et couplé optiquement au deuxième guide d'onde (24), s'étendant au moins dans la zone de report effectif Zrₑ, et présentant un espacement e_{gap}⁽³⁾, vis-à-vis de la face supérieure (20a), inférieure à la valeur seuil Pₜₕ prédéterminée.

4. Procédé de fabrication selon l'une quelconque des revendications 1 à 3, dans lequel, à la suite de l'étape de réalisation de la vignette (10), celle-ci présente des dimensions initiales Lv⁽ⁱ⁾, lv⁽ⁱ⁾ au moins égales respectivement à Lc+2dᵢₚ, 1c+2dᵢₚ.

5. Procédé de fabrication selon l'une quelconque des revendications 1 à 4, dans lequel la zone de report effectif Zrₑ présente des dimensions Lrₑ, 1rₑ au moins égales respectivement à Lc+4dᵢₚ, 1c+4dᵢₚ.

6. Procédé de fabrication selon l'une quelconque des revendications 1 à 5, comportant, avant l'étape de réalisation du composant optoélectronique, une étape de suppression d'un substrat de croissance (11) de la vignette (10) par gravure humide, celle-ci se traduisant par une sur-gravure latérale de la vignette (10) dans un plan parallèle au substrat de réception (20) sur une distance d_{sgl} non nulle, la vignette (10) présentant alors des dimensions initiales Lv⁽ⁱ⁾, lv⁽ⁱ⁾ prédéterminées à partir en outre de la distance d_{sgl}.

7. Procédé de fabrication selon l'une quelconque des revendications 1 à 6, comportant une étape de réalisation d'une pluralité de composants optoélectroniques à partir de la même vignette (10), chaque composant optoélectronique étant couplé au premier guide d'onde (23) correspondant.

8. Procédé de fabrication selon l'une quelconque des revendications 1 à 7, dans lequel le composant optoélectronique est une diode laser, une photodiode ou un modulateur électro-optique.

9. Procédé de fabrication selon l'une quelconque des revendications 1 à 8, dans lequel la vignette (10) est réalisée à base d'un composé semiconducteur III-V.

10. Procédé de fabrication selon l'une quelconque des revendications 1 à 9, le composant optoélectronique étant une diode laser DFB, un miroir de Bragg étant disposé dans le premier guide d'onde (23).

11. Procédé de fabrication selon l'une quelconque des revendications 1 à 9, le composant optoélectronique étant une diode laser de type DBR, deux miroirs de Bragg délimitant la cavité optique de la diode laser et disposés dans des deuxièmes guides d'onde (24) superposés et couplés optiquement chacun à une extrémité dudit premier guide d'onde (23) correspondant.

12. Procédé de fabrication selon l'une quelconque des revendications 1 à 8, assurant la fabrication simultanée d'une pluralité de puces photoniques (1) à partir du même substrat de réception (20).

## Patentansprüche

1. Verfahren zur Herstellung eines Photonenchips (1), der mindestens ein optoelektronisches Bauelement umfasst, das auf einem Aufnahmesubstrat (20) angeordnet und optisch mit einem ersten Wellenleiter (23) gekoppelt ist, der als integriert bezeichnet wird, wobei das Verfahren die folgenden Schritte umfasst:
o Bestimmung einer zentralen Zone Zc auf einer Oberseite (20a) des Aufnahmesubstrats (20), die vorbestimmte Abmessungen Lc, Ic in der Ebene des Aufnahmesubstrats aufweist und dazu bestimmt ist, vollständig von einer Vignette (10) nach einem Schritt der Übertragung derselben auf das Aufnahmesubstrat (20) unter Berücksichtigung einer vorbestimmten Ungenauigkeit der Positionierung dᵢₚ der Vignette (10) um die zentrale Zone Zc bedeckt zu werden;
o Erstellen der Vignette (10), die anfängliche Abmessungen Lv⁽ⁱ⁾, lv⁽ⁱ⁾ aufweist, die aus den Abmessungen Lc, Ic und der Ungenauigkeit der Positionierung dᵢₚ vorbestimmt sind;
o Erstellen des Aufnahmesubstrats (20), wobei die Oberseite (20a) die zentrale Zone Zc und eine periphere Zone Zp umfasst, die die zentrale Zone Zc umgibt und dazu vorgesehen ist, nach dem Übertragungsschritt teilweise von der Vignette bedeckt zu werden, die zusammen eine effektive Übertragungszone Zrₑ bilden, in der die Vignette dazu vorgesehen ist, sich ganz darin zu befinden, wobei das Aufnahmesubstrat (20) umfasst:
• den ersten Wellenleiter (23), der sich nur in den zentralen Bereich Zc erstreckt; und
• einen zweiten Wellenleiter (24), der über dem ersten Wellenleiter (23) angeordnet und optisch mit diesem gekoppelt ist, sich zumindest in der peripheren Zone Zp erstreckt und einen Abstand e_{gap}⁽²⁾ gegenüber der Oberseite (20a) aufweist, der größer als ein vorgegebener Schwellenwert Pₜₕ ist;
o Übertragung der Vignette (10) in die effektive Übertragungszone Zrₑ des Aufnahmesubstrats (20), wobei die zentrale Zone Zc dann vollkommen von der Vignette (10) bedeckt ist und die periphere Zone Zp dann eine freie Oberfläche (25) aufweist, die nicht von der Vignette bedeckt ist;
o Aufbringen einer Gravurmaske (31) auf einen Teil der Vignette (10) einerseits und rund um die effektive Übertragungszone Zrₑ andererseits;
o Erstellen des optoelektronischen Bauteils aus der Vignette (10) durch Trockengravur eines freien Teils der Vignette (10), der nicht mit der Gravurmaske (31) beschichtet ist, wobei die freie Oberfläche (25) der peripheren Zone Zp dann mit einer Tiefe P_{sgv}^{(a)}, die kleiner oder gleich dem Schwellenwert Pₜₕ ist, graviert wird.

2. Verfahren zur Herstellung nach Anspruch 1, bei dem der erste Wellenleiter (23) einen Abstand e_{gap}⁽¹⁾ von der Oberseite (20a) aufweist, der kleiner ist als der vorbestimmte Schwellenwert Pₜₕ.

3. Verfahren zur Herstellung nach Anspruch 1 oder 2, bei dem das Aufnahmesubstrat (20) einen dritten Wellenleiter umfasst, der über dem zweiten Wellenleiter (24) angeordnet und optisch mit diesem gekoppelt ist, sich zumindest in der effektiven Übertragungszone Zrₑ erstreckt und gegenüber der Oberseite (20a) einen Abstand e_{gap}⁽³⁾ aufweist, der kleiner als der vorbestimmte Schwellenwert Pₜₕ ist.

4. Verfahren zur Herstellung nach einem der Ansprüche 1 bis 3, bei dem nach dem Schritt der Herstellung der Vignette (10) diese die anfänglichen Abmessungen Lv⁽ⁱ⁾, Iv⁽ⁱ⁾ aufweist, die mindestens gleich Lc+2dᵢₚ, lc+2dᵢₚ sind.

5. Verfahren zur Herstellung nach einem der Ansprüche 1 bis 4, bei dem der effektive Übertragungsbereich Zrₑ die Abmessungen Lrₑ, Irₑ aufweist, die mindestens gleich Lc+4dᵢₚ, lc+4dᵢₚ sind

6. Verfahren zur Herstellung nach einem der Ansprüche 1 bis 5, das vor dem Schritt der Herstellung des optoelektronischen Bauteils einen Schritt der Abtragung eines Wachstumssubstrats (11) von der Vignette (10) durch Nassgravur umfasst, wobei diese in einer seitlichen Übergravur der Vignette (10) in einer Ebene parallel zum Aufnahmesubstrat (20) über einen Abstand d_{sgl} ungleich Null resultiert, wobei die Vignette (10) dann anfängliche Abmessungen Lv⁽ⁱ⁾, Iv⁽ⁱ⁾ aufweist, die zusätzlich ab dem Abstand d_{sgl} vorbestimmt sind.

7. Verfahren zur Herstellung nach einem der Ansprüche 1 bis 6, umfassend einen Schritt zur Herstellung einer Vielzahl von optoelektronischen Bauelementen aus der gleichen Vignette (10), wobei jedes optoelektronische Bauelement mit dem entsprechenden ersten Wellenleiter (23) gekoppelt ist.

8. Verfahren zur Herstellung nach einem der Ansprüche 1 bis 7, wobei das optoelektronische Bauelement eine Laserdiode, eine Fotodiode oder ein elektrooptischer Modulator ist.

9. Verfahren zur Herstellung nach einem der Ansprüche 1 bis 8, wobei die Vignette (10) auf der Basis einer III-V-Halbleiterverbindung erstellt wird.

10. Verfahren zur Herstellung nach einem der Ansprüche 1 bis 9, wobei das optoelektronische Bauelement eine DFB-Laserdiode ist und ein Bragg-Spiegel im ersten Wellenleiter (23) angeordnet ist.

11. Verfahren zur Herstellung nach einem der Ansprüche 1 bis 9, wobei das optoelektronische Bauelement eine Laserdiode vom Typ DBR ist, wobei zwei Bragg-Spiegel den optischen Hohlraum der Laserdiode begrenzen und in zweiten Wellenleitern (24) angeordnet sind, die übereinander liegen und jeweils optisch mit einem Ende des entsprechenden ersten Wellenleiters (23) gekoppelt sind.

12. Verfahren zur Herstellung nach einem der Ansprüche 1 bis 8, das die gleichzeitige Herstellung einer Vielzahl von photonischen Chips (1) aus demselben Aufnahmesubstrat (20) gewährleistet.

## Claims

1. A method for manufacturing a photonic chip (1) including at least one optoelectronic component disposed over a receiving substrate (20) and optically coupled to a so-called integrated first waveguide (23), the method including the following steps:
∘ defining a central area Zc, over an upper face (20a) of the receiving substrate (20), having predefined dimensions Lc, Ic in the plane of the receiving substrate, said area being intended to be entirely covered by a label (10) following a step of transferring the latter onto the receiving substrate (20) while allowing for a predefined uncertainty dᵢₚ in the positioning of the label (10) around the central area Zc;
∘ making the label (10), having initial dimensions Lv⁽ⁱ⁾, lv⁽ⁱ⁾ that are predetermined from the dimensions Lc, lc and of the positioning uncertainty dᵢₚ;
∘ making the receiving substrate (20), the upper face (20a) including the central area Zc, and a peripheral area Zp surrounding the central area Zc and intended to be partially covered by the label following the transfer step, together forming an actual transfer area Zrₑ in which the label is intended to be entirely located, the receiving substrate (20) including:
• the first waveguide (23), extending only in the central area Zc; and
• a second waveguide (24), superimposed with and optically coupled to the first waveguide (23), extending at least in the peripheral area Zp, and having a spacing e_{gap}⁽²⁾, with respect to the upper face (20a), larger than a predetermined threshold value Pₜₕ;
∘ transferring the label (10) into the actual transfer area Zrₑ of the receiving substrate (20), the central area Zc is then entirely covered by the label (10), and the peripheral area Zp then having a free surface (25) not covered by the label;
∘ depositing an etch mask (31) over a portion of the label (10), on the one hand, and around the actual transfer area Zrₑ, on the other hand;
∘ making the optoelectronic component from the label (10), by dry etching of a free portion of the label (10) not coated by the etch mask (31), the free surface (25) of the peripheral area Zp then being etched over a depth p_{sgv}^{(a)} smaller than or equal to the threshold value Pₜₕ.

2. The manufacturing method according to claim 1, wherein the first waveguide (23) has a spacing e_{gap}⁽¹⁾, with respect to the upper face (20a), smaller than the predetermined threshold value Pₜₕ.

3. The manufacturing method according to claim 1 or 2, wherein the receiving substrate (20) includes a third waveguide, superimposed with and optically coupled to the second waveguide (24), extending at least in the actual transfer area Zrₑ, and having a spacing e_{gap}⁽³⁾, with respect to the upper face (20a), smaller than the predetermined threshold value Pₜₕ.

4. The manufacturing method according to any one of claims 1 to 3, wherein, following the step of making the label (10), the latter has initial dimensions Lv⁽ⁱ⁾, lv⁽ⁱ⁾ at least equal to Lc+2dᵢₚ, lc+2dᵢₚ, respectively.

5. The manufacturing method according to any one of claims 1 to 4, wherein the actual transfer area Zrₑ has dimensions Lrₑ, Irₑ at least equal to Lc+4dᵢₚ, lc+4dᵢₚ, respectively

6. The manufacturing method according to any one of claims 1 to 5, including, before the step of making the optoelectronic component, a step of removing a growth substrate (11) of the label (10) by wet etching, the latter resulting in a lateral over-etching of the label (10) in a plane parallel to the receiving substrate (20) over a non-zero distance d_{sgl}, the label (10) then having initial dimensions Lv⁽ⁱ⁾, lv⁽ⁱ⁾ that are furthermore predetermined from the distance dsgi.

7. The manufacturing method according to any one of claims 1 to 6, including a step of making a plurality of optoelectronic components from the same label (10), each optoelectronic component being coupled to the corresponding first waveguide (23).

8. The manufacturing method according to any one of claims 1 to 7, wherein the optoelectronic component is a laser diode, a photodiode or an electro-optical modulator.

9. The manufacturing method according to any one of claims 1 to 8, wherein the label (10) is made based on a III-V semiconductor compound.

10. The manufacturing method according to any one of claims 1 to 9, the optoelectronic component being a DFB laser diode, a Bragg mirror being disposed in the first waveguide (23).

11. The manufacturing method according to any one of claims 1 to 9, the optoelectronic component being a DBR-type laser diode, two Bragg mirrors delimiting the optical cavity of the laser diode and disposed in second waveguides (24) superimposed with and each optically coupled to one end of said corresponding first waveguide (23).

12. The manufacturing method according to any one of claims 1 to 8, ensuring the simultaneous manufacture of a plurality of photonic chips (1) from the same receiving substrate (20).
